# EUROPEAN PATENT SPECIFICATION

(11) **EP 0 186 249 B1**
(45) Date of publication and mention of the grant of the patent: **27.01.1993**
(21) Application number: 85202098.1
(22) Date of filing: 18.12.1985
(51) Int. Cl.: C01B 33/02, B01D 9/00

(54) **Process for the preparation of polycrystalline materials and equipment suitable to the accomplishing thereof**
Verfahren zur Herstellung von polykristallinem Material und Vorrichtung dafür
Procédé pour la préparation de matériaux polycristallins et équipement à cet effet

(30) Priority: 21.12.1984 IT 2419684
(43) Date of publication of application: 02.07.1986
(73) Proprietor: AGIP S.p.A., 20121 Milano (IT)
(72) Inventor: Di Rese, Leonardo, I-00182 Rome (IT); Margadonna, Daniele, I-00040 Rocca Priora Rome (IT); Paraggio, Vincenzo, I-50132 Florence (IT); Scafe, Ernesto, I-00155 Rome (IT)
(74) Representative: Roggero, Sergio

(56) References cited:
- EP-A- 0 021 385
- EP-A- 0 055 318
- EP-A- 0 128 600
- EP-A- 0 141 999
- US-A- 4 243 471

## Description

The invention relates to a process for the preparation of polycrystalline materials, and to an equipment suitable to accomplish such a process.

More particularly, the present invention relates to a process for the preparation of polycrystalline silicon, and to an equipment suitable to the accomplishing thereof.

Hereinunder, reference shall be made in particular to polycrystalline silicon, it being however intended that the process according to the invention can be adapted to the preparation of any polycrystalline material obtainable by means of melting and unidirectional cooling.

The possibility has already been demonstrated in technical papers of using polycrystalline silicon, in lieu of monocrystalline silicon, for the manufacturing of photovoltaic cells. The problem is of obtaining polycrystalline silicon with columnar structure at a high purity level, low density of dislocations due to thermal stresses and hence with grains of large size relatively to the diffusion length of minor carriers, as the grain edges are recombination centres of above-said carriers, thus reducing photovoltaic devices' conversion efficiency.

The known art as hereinunder reported either is not able to solve the above mentioned problems, or solves them partially, with high costs.

Among the documents of known art, U.S. Patent N° 42565681 can be mentioned, which describes a method for obtaining polycrystalline silicon, with material's quality impairing. Silicon obtained by this method, known as UCP (Ubiquitous Crystallization Process) is characterized by the grains' random orienting. Such a process allows a polycrystalline material to be obtained with large enough grains, but it shows three drawbacks:
1) The random orientation of the grains favours the presence of whole grain walls inside the silicon chip;
2) The absence of a preferential direction of the growth front favours the trapping, inside the slab, of possible impurities present in the raw material;
3) The unavoidable presence of inner stresses due to the random advance of the growth front.

Other crystallization processes, deriving from the Bridgman-Stockbarger method, allow silicon for photovoltaic use to be obtained. The disadvatanges they show are:
1) The presence of moving parts, which renders the equipment expensive;
2) The great complexity of the equipment, which, in turn, renders a number of mechanical and thermal controls necessary, which reduce the reliability and increase the operating costs;
3) Such costs are further increased in that the power required to maintain the temperature differential during the solidifying step must be supplied over nearly the entire duration of the process. Another example of the prior art methods is EP-A-0 055 318, which discloses a method for producing doped semicrystalline silicon body for photovoltaic cells, which comprises forming a molten mass of silicon containing a dopant of a single conductivity type, and cooling the molten mass under carefully controlled conditions, particularly at the solidification point, so that crystallites having a mean diameter of at least 1 mm are formed randomly throughout the mass.

It has been surprisingly found that the drawbacks of the known art can be overcome, without resorting to moving parts and maintaining the columnar structure, by melting the material to be crystallized, and crystallizing it by cooling it from the bottom at a cooling rate comprised within the range of from 0,1°C/min to 3°C/min over an overall cooling time comprised within the range of from 10 hours to 30 hours.

More particularly, the present invention provides a process for producing polycrystalline silicon by melting and gradually cooling electronic grade silicon, characterizd in that it comprises the steps of:
1) charging doped electronic grade silicon to an open-top crucible having a heat insulating layer on the sidewall only;
2) applying heat to the upper lateral portion of the crucible so as to heat the top lateral portion of the doped electronic grade silicon to a temperature which is from 30°C to 100°C below the melting temperature of the charged silicon;
3) applying heat to the bottom portion of the charged silicon up to a temperature which exceeds the silicon melting point by from 30°C to 200°C;
4) causing the molten silicon to cool by gradually diminishing the heat supply to the silicon bottom portion at a rate of from 0,1°C/min to 3°C/min for a time of from 10 hors to 30 hours, and
5) removing the so formed polycrystalline silicon from the crucible.

The process according to the present invention envisages possibly an annealing of material cooled (item (4) at a temperature lower by 200-300°C than its melting temperature.

According to a first form of preferred embodiment of the process according to the present invention, the vessel is placed inside a chamber closed or substantially closed towards heat transmission, but in its lowermost zone, wherein the heat is transmitted to the outside by irradiation. Heat transmitted to the outside by irradiation during steps from 1 to 3 is absorbed, according to a second form of preferred embodiment of the process according to the present invention, by a thermal stabilizer kept at a temperature slightly higher than room temperature.

In particular, the thermal stabilizer is a heat absorber constituted by a sheet of conducting material cooled by indirect heat exchange with a fluid at room temperature, in particular water.

It should be observed that the heating as under item 1 can be carried out either by means of side heaters placed inside the chamber closed or substantially closed against heat transmission as previously mentioned, or by means of heaters installed under the vessel, or by means of both heaters said, the preferred form being that carried out by means of side heaters, and these consist in particular of a vertically extending resistor, placed all around the vessel containing the material to be melted and crystallized.

According to a third preferred form of embodiment of the process according to the invention, the chamber closed or substantially closed against heat transmission, as previously said, has an atmosphere controlled with inert gases continuously supplied from down upwards, or is under vacuum.

The inert gases which yield controlled atmosphere are drawn from above said chamber together with the possible gaseous products obtained during material's melting (gaseous products can be CO, SiO, H₂O), continuously from the side opposite to supplying side.

According to a fourth form of embodiment of the process according to the present invention, the cooling as of item 3) is gradual.

As far as the cooling as for item 3) is concerned, its times are comprised within the range of from 15 to 20 hours in case starting material is silicon comprising up to 5 ppm of impurities, whilst in case starting material is silicon containing more than 10 and up to 50 ppm of impurities, the time is comprised within the range of from 20 to 30 hours.

A second object of the present invention is an equipment suitable to the accomplishment of the previously described process.

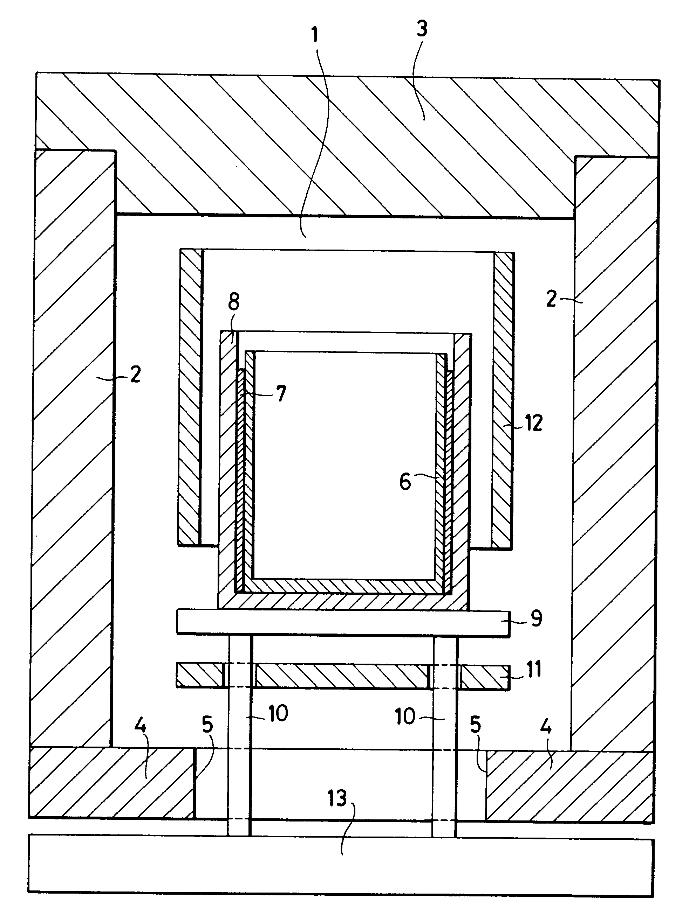

The equipment shall be now disclosed with reference to the drawing attached, which is not to be intended as limitative of the invention.

The equipment consists of a chamber (1) bounded by the side walls (2), in particular cylindrical or flat, internally of high-purity insulating material preferably selected between graphite felt and quarz wool, by the cover (3) internally of the same material as of walls, and by a bottom (4) provided with a port in particular with round or square cross section (5), internally always of the same material.

Inside the chamber the crucible (6) is placed, possibly internally coated with a release agent, and laterally thermally insulated with a layer (7) of the insulating material selected between those as above mentioned, both the crucible and the thermal insulator being slipped inside a graphite vessel (8).

The vessel (8) is supported by a plate (9) laying on refractory supports (10).

Under the graphite plate an electrical heater (11) is placed, having such power as to compensate for the heat loss due to irradiation through port (5), so that all meterial inside the crucible can be in the molten state.

Inside the chamber, an electrical heater (12) is placed, which surrounds with a suitable spacing, but in its lowermost zone, the vessel (8). The heater (12) extends beyond the top of vessels (8), in order to make it possible a higher temperature in the upper zone of chamber to be obtained.

Heat lost due to irradiation through the port (5) is absorbed by heat absorbing plates (13) preferably of copper, cooled with water at room temperature.

An example shall now be supplied to the purpose of better illustrating the invention, is being intended that the invention is not limited to it or by it.

### Example

Fifteen kg of electronic grade (off-grade) silicon, together with the proper amount of doper were placed inside the quarz crucible (6) internally coated with a layer of Si₃N₄.

The crucible surrounded by graphite felt (7) was placed inside the graphite vessel (8).

The electrical heater (12) was turned on, raising the chamber temperature up to 1350°C.

When the temperature of 1350°C was reached at the top of the vessel (8), the electrical heater (11) was turned on, raising the chamber temperature, in the same point, at 1500°C.

The whole was kept standing at said temperature over 30 minutes.

At this time, it was started decreasing the power of electrical heater (11), adjusting the cooling rate at 0.1° C/minute, over a 10 hour time.

The cooling rate was controlled by measuring the temperatures by means of thermocouples (not shown in figure) and adjusted by means of a suitably programmed computer. After 10 hours, the cooling rate was increased up to 2°C/minute, and then further increased up to reaching temperatures suitable to slab extraction.

The slab was extracted and cut into chips to verify the quality.

The slab showed a columnar structure with grain sizes of up to 1 cm in diameter.

Cells manufactured with such silicon chips had an efficiency of up to 10% without having optimized the cycle.

## Claims

1. Process for producing polycrystalline silicon by melting and gradually cooling electronic grade silicon, characterized in that it comprises the steps of:
1) charging doped electronic grade silicon to an open-top crucible having a heat insulating layer on the sidewall only;
2) Applying heat to the upper lateral portion of the crucible so as to heat the top lateral portion of the doped electronic grade silicon to a temperature which is from 30°C to 100°C below the melting temperature of the charged silicon;
3) Applying heat to the bottom portion of the charged silicon up to a temperature which exceeds the silicon melting point by from 30°C to 200°C;
4) Causing the molten silicon to cool by gradually diminishing the heat supply to the silicon bottom portion at a rate of from 0,1°C/min to 3°C/min for a time of from 10 hours to 30 hours, and
5) Removing the so formed polycrystalline silicon from the crucible.

2. Process according to Claim 1, further comprising the step of absorbing the heat irradiated by the crucible bottom by means of a heat absorbing plate cooled to ambient temperature and positioned beneath the crucible.

3. Apparatus for performing the process of Claim 1 or 2, consisting of:
a) an open-top crucible (6) having a heat-insulating liner (7) on its sidewall;
b) a vessel (8) completely enclosing the crucible bottom and insulated sidewall;
c) a plate (9) for supporting said crucible (6) and said vessel (8);
d) refractory supports (10) sustaining said plate (9) and connecting it to an underlying heat-absorbing plate (13);
e) a first electric heater (12) spaced apart from, and encircling, the top portion of the crucible-vessel assembly (6,7,8);
f) a second electric heater (11) placed beneath said supporting plate (9), and
g) a chamber(1), having a lid (3), sidewalls (2) and bottom wall (4) fitted with a port (5) to allow passage to said refractory supports (10) and to the radiant heat to be collected by said underlying heat-absorbing plate.

4. Apparatus according to Claim 3, wherein said heat-absorbing plate (13) is made of copper and has coolant circulation means.

5. Apparatus according to Claim 3, wherein said chamber (1) has means for feeding an upwardly flowing inert gas stream thereinto.

6. Apparatus according to Claim 3, wherein said chamber (1) has means for creating a vacuum in its interior.

7. Apparatus according to Claim 3, wherein the crucible heat-insulating layer (7) is made of graphite felt or quartz wool.

8. Apparatus according to Claim 3, wherein the lid,(3) and the walls (2, 4) of the chamber (1) are made of a heat insulating material selected from graphite felt or quartz wool.

9. Apparatus according to Claim 3, wherein a release material is applied to the crucible (6) interior.

## Patentansprüche

1. Verfahren zum Herstellen von polykristallinem Silizium durch Schmelzen und allmähliches Abkühlen von Silizium in Elektronikqualität, dadurch gekennzeichnet, daß es die folgenden Schritte umfaßt:
1) Einbringen von dotiertem Silizium in Elektronikqualität in einen oben offenen Schmelztiegel mit einer Wärmeisolationsschicht, die nur auf seiner Seitenwand angeordnet ist;
2) Zuführen von Wärme zum oberen Querabschnitt des Schmelztiegels, um den oberen Querabschnitt des dotierten Elektronikqualität-Siliziums auf eine Temperatur von 30°C bis 100°C unterhalb der Schmelztemperatur des eingebrachten Siliziums zu erhitzen;
3) Zuführen von Wärme zum unteren Abschnitt des eingebrachten Siliziums bis zu einer Temperatur, welche den Siliziumschmelzpunkt um 30°C bis 200°C übersteigt;
4) Veranlassen der Abkühlung des geschmolzenen Siliziums durch allmähliches Verringern der Wärmezufuhr zum unteren Siliziumabschnitt mit einer Geschwindigkeit von 0,1°C/min bis 3°C/min über eine Zeitspanne von 10 Stunden bis 30 Stunden, und
5) Entfernen des so gebildeten polykristallinen Siliziums aus dem Schmelztiegel.

2. Verfahren nach Anspruch 1, weiters mit dem Schritt des Absorbierens der vom Schmelztiegelboden abgestrahlten Wärme mit Hilfe einer wärmeabsorbierenden Platte, die auf Umgebungstemperatur gekühlt und unterhalb des Schmelztiegels angeordnet ist.

3. Vorrichtung zum Ausführen des Verfahrens nach Anspruch 1 oder 2, bestehend aus:
a) einem oben offenen Schmelztiegel (6) mit einer wärmeisolierenden Auskleidung (7) an seiner Seitenwand;
b) einem den Schmelztiegelboden und die isolierte Schmelztiegelseitenwand vollständig umschließenden Gefäß (8);
c) einer Platte (9) zum Abstützen des Schmelztiegels (6) und des Gefäßes (8);
d) hitzebeständigen Trägern (10), welche die Platte (9) tragen und sie mit einer darunterliegenden wärmeabsorbierenden Platte (13) verbinden;
e) einer ersten elektrischen Heizeinrichtung (12), welche den oberen Teil der Schmelztiegel/Gefäß-Anordnung (6, 7, 8) mit Abstand umgibt;
f) einer zweiten elektrischen Heizeinrichtung (11), die unterhalb der abstützenden Platte (9) angeordnet ist, und
g) einer Kammer (1) mit einem Deckel (3), Seitenwänden (2) und einem mit einer Öffnung (5) ausgestatteten Boden (4), um den Durchtritt der hitzebeständigen Träger (10) und das Sammeln der Strahlungswärme durch die darunterliegende wärmeabsorbierende Platte zu gestatten.

4. Vorrichtung nach Anspruch 3, bei welcher die wärmeabsorbierende Platte (13) aus Kupfer gefertigt ist und Mittel zur Zirkulation eines Kühlmediums aufweist.

5. Vorrichtung nach Anspruch 3, bei welcher die Kammer (1) Mittel zum Einleiten eines aufwärts strömenden inerten Gasstromes aufweist.

6. Vorrichtung nach Anspruch 3, bei welcher die Kammer (1) Mittel zum Erzeugen eines Vakuums in ihrem Inneren aufweist.

7. Vorrichtung nach Anspruch 3, bei welcher die Wärmeisolationsschicht (7) des Schmelztiegels aus Graphitfilz oder Quarzwolle gefertigt ist.

8. Vorrichtung nach Anspruch 3, bei welcher der Deckel (3) und die Wände (2, 4) der Kammer (1) aus einem wärmeisolierenden Material gefertigt sind, das aus Graphitfilz oder Quarzwolle gewählt ist.

9. Vorrichtung nach Anspruch 3, bei welcher auf die Innenseite des Schmelztiegels (6) ein Trennmittel aufgebracht ist.

## Revendications

1. Procédé de production de silicium polycristallin par fusion et refroidissement progressif du silicium de qualité électronique, caractérisé par le fait qu'il comprend les étapes suivantes :
1) charger du silicium dopé de qualité électronique dans un creuset ouvert à sa partie supérieure et ayant une couche isolante uniquement aux parois latérales;
2) appliquer la chaleur à la partie latérale supérieure du creuset de façon à chauffer la partie latérale supérieure du silicium dopé de qualité électronique, à une température allant de 30°C à 100°C en dessous de la température de fusion du silicium chargé;
3) chauffer la partie inférieure du silicium chargé jusqu'à une température qui dépasse de 30 à 200°C la température de fusion de silicium;
4) provoquer le refroidissement du silicium fondu en diminuant progressivement la chaleur fournie à la partie inférieure du silicium, à une vitesse allant de 0,1°C/min à 3°C/min, pendant une durée de 10 à 30 heures, et
5) retirer le silicium polycristallin ainsi formé du creuset.

2. Procédé selon la revendication 1, comprenant en outre l'étape consistant à absorber la chaleur irradiée par le bas du creuset, au moyen d'une plaque absorbant la chaleur refroidie à température ambiante et placée en dessous du creuset.

3. Appareil pour la mise en oeuvre du procédé selon la revendication 1 ou 2, constitué :
a) d'un creuset (6) ouvert à sa partie supérieure et ayant une garniture isolante (7) sur ses parois;
b) d'un récipient (8) entourant complètement le bas du creuset et les parois isolantes;
c) d'une plaque (9) supportant le creuset (6) et le récipient (8);
d) de supports réfractaires (10) soutenant la plaque (9) et la reliant à une plaque isolante (13) sous-jacente;
e) d'un premier élément chauffant (12) entourant à distance la partie supérieure de l'ensemble creuset-récipient (6, 7, 8);
f) d'un second élément chauffant (11) placé en dessous de la plaque de support (9), et
g) d'une chambre (1) ayant un couvercle (3), des parois (2) et une paroi de fond (4) pourvue d'une ouverture (5) permettant le passage des supports réfractaires (10) et de la chaleur radiante devant être recueillie par la plaque sous-jacente absorbant la chaleur.

4. Appareil selon la revendication 3, où la plaque (13) absorbant la chaleur est faite de cuivre et comporte des moyens de circulation pour le refroidissement.

5. Appareil selon la revendication 3, où la chambre (1) comporte des moyens pour y laisser entrer un courant de gaz inerte ascendant.

6. Appareil selon la revendication 3, où la chambre (1) comporte des moyens pour créer le vide à l'intérieur.

7. Appareil selon la revendication 3 où la couche isolante du creuset est faite de feutre de graphite ou de laine de quartz.

8. Appareil selon la revendication 3 où le couvercle (3) et les parois (2,4) de la chambre (1) sont faits d'une matière isolante choisie parmi le feutre de graphite et la laine de quartz.

9. Appareil selon la revendication 3, où une matière lubrifiante ou de démoulage est appliquée à l'intérieur du creuset (6).
